# EUROPÄISCHE PATENTSCHRIFT

(11) **EP 2 577 090 B1**
(45) Veröffentlichungstag und Bekanntmachung des Hinweises auf die Patenterteilung: **14.01.2015**
(21) Anmeldenummer: 11754980.8
(22) Anmeldetag: 27.05.2011
(51) Int. Cl.: B64C 27/00, B64D 45/00, F16F 15/02, H01L 41/09, H02N 2/00, B06B 1/06, F16F 7/10

(54) **KRAFTGENERATOR ZUR ANBRINGUNG AN EINER STRUKTUR**
FORCE GENERATOR FOR MOUNTING ON A STRUCTURE
GÉNÉRATEUR DE FORCE À MONTER SUR UNE STRUCTURE

(30) Priorität: 28.05.2010 DE 102010021867
(43) Veröffentlichungstag der Anmeldung: 10.04.2013
(73) Patentinhaber: AIRBUS HELICOPTERS DEUTSCHLAND GmbH, 86609 Donauwörth (DE)
(72) Erfinder: STORM, Stefan, 85716 Unterschleissheim (DE); PRIEMS, Martijn, 85579 Neubiberg (DE)
(74) Vertreter: Schmid, Rudolf
(86) Internationale Anmeldenummer: PCT/DE2011/001193
(87) Internationale Veröffentlichungsnummer: WO 2011/153996

(56) Entgegenhaltungen:
- EP-A1- 1 528 281
- EP-A1- 1 927 782
- DE-A1-102005 060 779
- DE-A1-102006 053 421

## Beschreibung

Die Erfindung betrifft einen Kraftgenerator zur Anbringung an einer Struktur, um steuerbar Schwingungskräfte zur Schwingungsbeeinflussung in die Struktur einzuleiten.

Kraftgeneratoren dienen dazu, mittels einer vorbestimmten Inertialmasse eine gewünschte Kraft zu erzeugen. Diese Kraft resultiert dabei stets aus einer Trägheit der wie auch immer bewegten Inertialmasse. Um eine möglichst hohe Kraft zu erzeugen, kann die Inertialmasse mit einer möglichst hohen Beschleunigung bzw. hohen Auslenkung bewegt werden oder alternativ lässt sich eine hohe Kraft auch durch eine möglichst hohe Inertialmasse generieren.

Derartige Kraftgeneratoren sind Bestandteil eines mechatronischen Systems bestehend aus Sensorik, Leistungselektronik und Prozessrechner und werden beispielsweise zum gezielten Einleiten von Kräften in schwingenden Strukturen, insbesondere bei Luftfahrzeugen verwendet, um hohen Schwingungspegeln entgegenzuwirken bzw. diese auszulöschen. Dabei treten insbesondere dann Probleme auf, wenn die Frequenz der zu regelnden Struktur mehr oder weniger stark variiert, wie es beispielsweise bei unterschiedlichen Betriebszuständen der schwingenden Struktur der Fall sein kann. Derartige unterschiedliche Betriebszustände ergeben sich oder werden gezielt eingestellt, z.B. bei Luftfahrzeugen aufgrund unterschiedlicher Flugphasen, insbesondere beim Start sowie bei der Landung. Vor allem bei Drehflüglern variieren die Drehzahlen der Rotoren relativ stark und die durch die Rotoren bewirkten Schwingungen haben erhebliche Amplituden, was für den Flugzeugführer und die Passagiere der Drehflügler zu massiven Beeinträchtigungen (z.B. Verkürzung der Arbeitszeit aufgrund erhöhter Vibrationsbelastung "EU Directive 2002/44/CE", Ablesbarkeit der Instrumente) führen kann.

Beispielsweise aus der DE 10 2005 060 779 ist ein Kraftgenerator bekannt, bei dem ein Biegearm mit einer daran befestigten Inertialmasse vorgesehen ist, und am Biegearm mehrere piezoelektrische Wandler montiert sind, die gegenphasig betrieben den Biegearm elastisch verformen, und dadurch die Inertialmasse zu Schwingungen anregen. Durch gezielte Ansteuerung der piezoelektrischen Wandler lassen sich störende Vibrationen an ausgewählten Sensorpunkten bei unterschiedlichen Frequenzen kompensieren. In der Regel ist die äußere Krafterregung um ein vielfaches höher (z.B. Faktor 4) als die benötigte aktive Kraft. Das bedeutet, dass der Kraftgenerator stärker verformt wird, als er selbst Wegamplituden generieren kann. Somit muss der piezoelektrische Wandler an geeigneter Stelle integriert werden, um den hohen dynamischen Belastungen standhalten zu können. Derartige Kraftgeneratoren erfordern eine relativ große Länge des Federarmes, da die piezoelektrischen Wandler nur in geringem Umfang einer Biegeverformung ausgesetzt und nicht auf Zug belastet werden dürfen. Auf Grund des durch die zulässige Biegbarkeit der Piezowandler vorgegebenen maximal zulässigen Krümmungsradius des Federarmes an den Schwingungsumkehrpunkten ist somit die Länge des erforderlichen Einbauraumes vorgegeben.

Um eine Anpassung des Kraftgenerators an Schwingungen erheblich unterschiedlicher Frequenzen zu ermöglichen, ist es dabei möglich, die Position der Inertialmasse entlang des Federarmes zu verändern. Nachteilig bei den vorbekannten Systemen ist neben der Baugröße der Umstand, dass konstruktionsbedingt bei der Krafterzeugung mittels einer an einem Hebel schwingenden Inertialmasse meist unerwünschte Momente entstehen und ausschließlich eine Vibrationsminimierung am Befestigungspunkt des Gesamtsystems erreicht wird (Tilgerfunktion).

Aus der DE 10 2006 053 421 A1 ist ein Kraftgenerator gemäß dem Oberbegriff des Anspruchs 1 bekannt, bei dem ein Biegearm U-förmig ausgebildet ist und nahe dem strukturseitigen Ende ein Piezowandler angebracht ist.

Aus der EP 1 927 782 A1 ist ein aktiver Tilger bekannt, der zwei entgegengesetzt zueinander sich erstreckende Federarme aufweist, an denen jeweils beidendig paarweise Piezowandler befestigt sind. Die beiden freien Federarmenden sind mit einer Inertialmasse gekoppelt.

Hiervon ausgehend liegt der Erfindung die Aufgabe zugrunde, einen gattungsgemäßen Kraftgenerator anzugeben, der sich durch eine geringe Baugröße, geringe unerwünschte Momente und geringen elektrischen Leistungsbedarf auszeichnet.

Erfindungsgemäß wird diese Aufgabe durch die im unabhängigen Anspruch 1 angegebenen Merkmale gelöst.

Die erfindungsgemäße Lösung ist dadurch gekennzeichnet, dass an beiden Enden des Federarmes jeweils mindestens ein Piezowandler angebracht ist und ferner ein Biegearm am Federarm angebracht ist, an dessen Ende die Inertialmasse befestigt ist. Während des Herstellungsprozesses wird der Piezowandler vorgespannt (z.B. mechanische Vorspannung während des Klebeprozesses und/oder Ausnutzung der unterschiedlichen Ausdehnungskoeffizienten beim Klebeprozess unter erhöhter Temperatur), damit er während des Betriebes keine nennenswerte Zugspannung erfährt.

Bei vernachlässigender Drehträgheit der Inertialmasse ist der Schwerpunkt der Inertialmasse in Höhe der Mitte des Federarmes angeordnet, also die Länge des Biegearms mit Inertialmasse ist halb so lang wie die Länge des Federarmes. Dies bewirkt, dass durch äußere Krafterregung dieser sich passiv S-förmig verformt (also quasi einen S-Schlag macht) was dazu führt, dass das (freie) Schwingungsende des Federarmes stets den gleichen konstanten Winkel aufweist, der demjenigen des Fixierendes im wesentlichen entspricht. Es ergibt sich also vorteilhafterweise eine Parallelverschiebung des Biegearm-Angriffspunktes. Ebenfalls eine aktive S-förmige Verformung wird durch die elektrische Ansteuerung der piezoelektrischen Wandler erreicht, die ebenfalls zu einer Parallelverschiebung des Biegearm-Angriffspunktes führt. Unabhängig von äußerer Erregung und elektrischer Ansteuerung wird bei einer Überlagerung der beiden Verformungen somit immer eine Parallelverschiebung des Biegearm-Angriffspunktes erzwungen und damit die piezoelektrischen Wandler an den beiden Enden des Federarmes in derselben Größenordnung belastet. Aufgrund der Parallelverschiebung des Biegearm-Angriffspunktes ist es möglich am Schwingungsende einen Biegearm ohne zusätzliche Führungselemente anzubringen, der sich in Richtung Fixierende parallel zum Federarm (im Ruhezustand betrachtet) des Federarmes erstreckt und an dessen Ende die Inertialmasse angebracht ist.

Durch diese Konstruktion ist eine Krafterzeugung möglich, die einem herkömmlichen System mit ungefähr dem 1,5-fach verlängerten Federarm entspricht, während gleichzeitig die unerwünschten Momente lediglich so groß sind wie bei einem herkömmlichen System mit 50% kürzerem Federarm, weil der Massenschwerpunkt auf der halben Länge des Federarmes liegt. Dies hat den Vorteil, dass die Inertialmasse deutlich näher am Fixierende angeordnet ist, wodurch die entstehenden und in die Struktur eingeleiteten unerwünschten Momente erheblich reduziert werden. Die Inertialmasse lässt sich erfindungsgemäß bei der halben Federlänge bzw. noch dichter am Fixierende des Federarmes anordnen, wodurch die unerwünschten Momente in einer Ausführungsform der Erfindung halbiert, in einer weiteren Ausführungsform fast zu Null werden.

Diese signifikante Reduzierung der Schwingungen, vor allem in Luftfahrzeugen, insbesondere Hubschraubern, ermöglicht in der Zukunft einen längerfristigen Betrieb solcher Geräte, denn zukünftig wird die Einsatzzeit für Personen, die Schwingungen ausgesetzt sind (z.B. Piloten), durch Verordnungen eingeschränkt werden.

Die Erfindung sieht vor, dass die Inertialmasse und/oder der Biegearm mit der Inertialmasse austauschbar ist. Auf diese Weise lässt sich mit geringem baulichen Aufwand ein "Seriensystem" bereitstellen, bei dem ein aktives Grundsystem bestehend aus dem Federarm bzw. den Federarmen mit angebrachten Piezowandlerpaaren mit einem austauschbaren passiven Resonatorsystem koppelbar ist, das an sehr unterschiedliche Schwingungsbedingungen angepasst werden kann. Es kann standardmäßig das immer gleiche aktive Grundsystem - bestehend aus dem Federarm mit den Piezowandlern - zugrunde gelegt werden und mittels eines angepassten Resonatorsystems (entweder nur eine austauschbare Inertialmasse oder ein austauschbares System bestehend aus einer Inertialmasse zusammen mit einem Biegearm) eine Anpassung an die Einsatzfrequenz erfolgen. Der Hauptteil der Massenbewegung wird hier passiv weich aufgenommen und die damit erzeugten dynamischen Kräfte bewirken nur eine geringe Verformung des aktiven Systems, und somit treten praktisch keine Zugkräfte in den vorgespannten Piezokeramiken auf. Somit ermöglicht dieser Aufbau für das Gesamtsystem eine erhöhte Entwurfsfreiheit. Ein entscheidender Vorteil liegt also im "Familienkonzept", so dass der erfindungsgemäße Kraftgenerator an eine Vielzahl von Anwendungen (z.B. Luftfahrzeuge unterschiedlicher Größen) anpassbar ist, weil nur eine Adaption des baulich einfachen Resonatorteils erforderlich ist.

Bei dieser Ausführung ist der Biegearm mit der Inertialmasse Lösbar am Schwingungsende angebracht.

Gemäß einer vorteilhaften Weiterbildung der Erfindung umfasst der Federarm eine Mittellage und zwei damit gekoppelte Decklagen, wobei die Piezowandler jeweils zwischen der Mittellage und einer der Decklagen angeordnet sind. Auf diese Weise lassen sich die Piezowandler sehr einfach im Inneren des Federarmes anordnen und diese brauchen auch nicht notwendigerweise - wie bisher üblich - am Federarm angeklebt werden, so dass die Montage deutlich vereinfacht wird. Vorzugsweise ist der restliche Bereich zwischen den Decklagen und der Mittellage mit geeignetem Füllmaterial, vorzugsweise GFK aufgefüllt, wodurch eine Verbindung der verschiedenen Lagen miteinander erreicht wird und eine Abstützungsmöglichkeit für die Piezowandler. Alternativ ist es auch möglich, die Piezowandler jeweils fast halb so lang auszubilden wie der Federarm, so dass zwischen den Piezowandlern nur ein kurzer Bereich mit Füllmaterial verbleibt.

Gemäß einer weiteren vorteilhaften Weiterbildung der Erfindung weist der Federarm in Schwingungsrichtung betrachtet eine rechteckige oder taillierte Form auf. Die rechteckige Form ist einfach in der Herstellung. Als taillierte Form ist eine Doppeltrapezform mit oder ohne verengtem Mittelbereich bevorzugt. Aufgrund der Taillierung wird ein gleichmäßigerer Krümmungsverlauf erreicht und somit wird auch der piezoelektrische Wandler gleichmäßiger belastet. Die Doppeltrapezform ohne verengten Mittelbereich hat einen verbesserten Wirkungsgrad und eine hohe Kopplung. Durch einen verengten Mittelbereich lässt sich eine definierte Serien-Federsteifigkeit im Mittelbereich erreichen.

Eine vorteilhafte Weiterbildung dieser Ausbildung sieht vor, dass sich die Decklagen von beiden Enden her ein Stück weiter als die Piezowandler erstrecken und dort mittels Stützabschnitten mit der Mittellage verbunden sind, wobei sich die Piezowandler an den Stützabschnitten abstützen, so dass im mittleren Bereich des Federarmes nur die Mittellage vorhanden ist. Diese Ausbildung ermöglicht es, den mittleren Bereich des Federarmes weicher zu gestalten, was den Vorteil hat, dass die Seriensteifigkeit aus dem Federarm und dem Biegearm reduzierbar ist.

Ein weiterer Vorteil dieser erfindungsgemäßen Ausbildung ist, dass durch die Sförmige Verformung des Federarmes mehr Energie umgewandelt werden kann als bei einem einfachen Biegebalken, was zu einer höheren Effizienz des Kraftgenerators führt.

Gemäß einer weiteren vorteilhaften Weiterbildung der Erfindung ist am Ende eines jeden Federarmes ein sich in Gegenrichtung erstreckender, zweiter Federarm mit beidendig angebrachten Piezowandlern angebracht, an dessen anderem Ende ein Biegearm mit Inertialmasse angebracht ist. Dadurch lässt sich der aktive Hub der Inertialmasse und damit die erzeugbare Kraft erheblich vergrößern.

Weiterhin ist eine Regeleinheit zur Ansteuerung des Kraftgenerators vorgesehen.

Beispielhaft ist an beiden Enden des Federarmes je ein Piezowandler vorgesehen. Dabei ist es möglich, beide Piezowandler auf der gleichen Seite des Federarmes vorzusehen, was den Vorteil eines geringen Fertigungsaufwandes hat. Alternativ können die beiden Piezowandler auf gegenüberliegenden Seiten des Federarmes angeordnet sein, so dass diese gleichphasig angesteuert werden können.

Beispielhaft sind an beiden Enden des Federarmes je zwei sich bezüglich der neutralen Faser des Federarmes gegenüberliegende und gegenphasig angesteuerte Piezowandler vorgesehen. Bei dieser Anordnung werden die sich jeweils kreuzweise gegenüberliegenden Piezowandler gemeinsam angesteuert. Diese Ausbildung hat die beste Aktuatorleistung und angesichts der symmetrischen Anordnung und Ansteuerung liegt die neutrale Faser unabhängig von der elektrischen Ansteuerung in der Mitte des Federarmes und somit erfolgt ein symmetrischer Ausschlag. Darüber hinaus können die Piezoabmessungen unabhängig von den Materialeigenschaften des Federarmes (E-Modul, Dicke) gewählt werden.

Beispielhaft ist der Biegearm halb so lang wie der Federarm ausgeführt. Dadurch ergibt sich eine ausgeglichene Momentenverteilung im Federarm .

Alternativ oder zusätzlich kann der Federarm eine rechteckige oder taillierte Längsschnittform aufweisen. Die Vorteile sind im Wesentlichen die gleichen wie oben beschrieben.

Ein weiteres Beispiel sieht vor, dass beiderseits des Federarmes zwei dazu parallele Führungsfedern angeordnet sind, deren jeweils erste Enden ebenfalls an der Struktur befestigt sind und deren jeweils zweite Enden gemeinsam mit dem Schwingungsende des Federarmes an einem Verbindungsteil starr angebracht sind, wobei der Biegearm am Verbindungsteil angebracht ist. Bei dieser Ausbildung wird das Verbindungsteil zwangsgeführt, so dass dieses (bis auf die durch die Biegeverformungen bewirkten Verkürzungen) parallel zu den Fixierenden schwingt. Auf Grund dieser Zwangsführung ist es wiederum möglich, den Biegearm länger auszubilden als bei der vorgenannten Ausführungsform (bei der die Inertialmasse in Höhe der Mitte des Federarmes angeordnet ist) und somit die Inertialmasse beliebig nahe an der Struktur bzw. dem Fixierende des Federarmes angeordnet sein kann. Es ist sogar möglich, den Schwerpunkt der Inertialmasse direkt in Höhe des Fixierendes anzuordnen, wodurch Momente vollständig vermieden werden können und somit nur die erwünschten hohen durch die Schwingung der Inertialmasse bewirkten Kräfte entstehen.

Ein alternatives Beispiel sieht vor, dass mindestens zwei mit Piezowandlern versehene Federarme parallel zueinander vorgesehen sind, deren Fixierenden an der Struktur befestigt sind und deren Schwingungsenden mittels eines Verbindungsteils miteinander starr verbunden sind, wobei der Biegearm am Verbindungsteil angebracht ist. Bei dieser Ausbildung wird die erzwungene Schwingung des Verbindungsteils parallel zu den beiden Fixierpunkten durch die mindestens zwei gleichartigen Federarme bewirkt, die durch die übereinstimmende Ansteuerung der Piezowandlerpaare parallel zueinander S-förmig verformbar sind. Auch bei dieser Ausbildung lässt sich die Inertialmasse beliebig dicht an die Struktur heranbringen. Die Anzahl der parallel angeordneten mit Piezowandlern versehenen Federarme gibt den Faktor an, mit dem sich auch die erzeugbare Kraft eines Federarmes vervielfacht.

Ein Beispiel sieht vor, dass beidseits im Bereich des Fixierendes am Federarm zwei entgegengesetzt sich erstreckende Hebelarme vorgesehen sind, und zwei gegenphasig ansteuerbare Piezowandler sich mit ihren jeweils einen Enden an der Struktur abstützen und sich mit ihren jeweils zweiten Enden an den beiden Hebelarmen zur gemeinsam wirkenden Biegung des Federarm abstützen. Bei diesem Beispiel sind die Piezowandler berührungsfrei neben dem Federarm angeordnet, was sowohl die Montage vereinfacht, als auch eine Reparatur im Falle einer Beschädigung eines Piezowandlers erst ermöglicht.

Dadurch dass sich die Piezowandler beidendig an den jeweiligen anderen Bauteilen (der Struktur bzw. den Hebelarmen) abstützen und beim Einbau gestaucht (ca. 1 Promille) und damit vorgespannt werden, besteht auch keine Gefahr von unerwünschten Zugbelastungen im Piezokristall, wodurch sich die Gefahr von Schäden reduziert.

Dieses Beispiel hat den Vorteil einer hohen mechanischen Kopplung des Systems und einer geringen Vorspannung, da keine unerwünschte Parallelsteifigkeit durch aufgeklebte Piezowandler vorhanden ist und der Piezowandler nur geringfügig gekrümmt wird, da Festkörpergelenke beidendig an den Piezowandlern angeordnet werden können. Ferner kann die Länge der Piezoelemente unabhängig von der Federlänge gewählt werden, da die gewünschte Momenteinleitung durch die Länge der Hebelarme bestimmt werden kann (entweder kurze Piezowandler mit kurzen Hebelarmen oder lange Piezowandler mit langen Federarmen). Ein weiterer Vorteil besteht darin, dass größere aktive Wege am Hebelarm generiert werden, wodurch die Krafteinleitung in einem besseren Abstand von der neutralen Phase erfolgen kann. Damit sind keine hohen Vorspannkräfte wie bei herkömmlichen Anordnungen erforderlich. Ein weiterer Vorteil besteht darin, dass die Befestigung der Inertialmasse mit Federarm nahe am Fixierende (der Einspannstelle) und unabhängig von der Dimensionierung der Aktuatorik (Piezowandler und Hebelarm) dimensionierbar ist. Damit treten geringere Momente am Fixierende auf, da sich die Inertialmasse näher am Fixierende befindet als bei herkömmlichen Anordnungen.

Ein Beispiel sieht vor, dass das Fixierende des Federarmes als vorzugsweise konvexe Wälzfläche ausgebildet ist, die sich gegen eine strukturseitige entgegengesetzt geformte, also vorzugsweise konkave Gegenwälzfläche abstützt. Der Federarm ist bei dieser Ausführung also mechanisch nicht an der Struktur befestigt, sondern wird lediglich durch den Druck der beiden Piezowandler gegen die Struktur gedrückt. Es entstehen bei dieser Ausführung vorteilhafterweise keine Rückstellmomente. Die federarmseitige Wälzfläche kann auch konvex und die strukturseitige konkav geformt sein, um im wesentlichen die gleiche Wirkung zu erzielen.

Ein weiteres Beispiel sieht vor, dass die beiden an den Hebelarmen angreifenden Piezowandler mit ihren anderen Enden an je einer Zwischenstütze befestigt sind und die beiden Zwischenstützen jeweils an einem weiteren Piezowandler befestigt sind, die sich jeweils parallel zu den beiden Piezowandlern erstrecken und gegenphasig zu diesen ansteuerbar sind und sich mit ihren anderen Enden an der Struktur abstützen. Bei dieser Ausbildung wirken die zwei jeweils über eine Zwischenstütze verbundenen Piezowandler wie ein einzelner Piezowandler der Baulänge beider mechanisch "hintereinander geschalteten" Piezowandler zusammen. Zwischen Struktur und Zwischenstütze ist zusätzlich ein weiches Federelement notwendig, das für eine nahezu konstante Vorspannung der Piezowandler sorgt. Dieses Vorspannelement erfüllt gleichzeitig den Zweck, ein Ausknicken der Piezowandler senkrecht zur Ausdehnungsrichtung zu verhindern. Es wird also bei kompakter Anordnung und geringer Baulänge ein größerer aktiver Weg erreicht, wodurch ein größerer Abstand zur neutralen Faser des Federarmes oder eine kürzere Baulänge möglich ist. Gleichzeitig ist die Anordnung in so weit baulich einfacher, als sich auch die Aktuatorik auf der Strukturseite abstützen kann, an der auch der Federarm angebracht ist.

Ein weiteres Beispiel sieht vor, dass die beiden an den Hebelarmen angreifenden Piezowandler mit ihren jeweils anderen Enden an einem mittig drehbar fixierten Wippenteil angreifen und am Wippenteil zwei weitere Piezowandler angreifen, die sich jeweils parallel zu den beiden ersten Piezowandlern erstrecken und gegenphasig zu diesen ansteuerbar sind und sich mit ihren anderen Enden an der Struktur abstützen. Die Vorspannung der Piezowandler erfolgt mittels Stauchung beim Einbau. Diese Ausbildung einer gefalteten Aktuatorik hat den Vorteil, dass im Gegensatz zur vorbeschriebenen Ausführungsform keine parallel geschaltete Vorspännfeder erforderlich ist und damit ein größerer aktiver Hub resultiert.

Ein weiteres Beispiel sieht vor, dass drei zueinander parallele Federarme vorgesehen sind, die sich jeweils mit einem Ende an der Struktur abstützen und jeweils mit dem anderen Ende an einem Verbindungsteil befestigt sind, wobei am mittleren Federarm zwei abstehende Hebelarme vorgesehen sind, an denen sich zwei Piezowandler jeweils mit ihrem einen Ende abstützen und sich die Piezowandler jeweils mit ihrem zweiten Ende über je ein mit dem Verbindungsteil verbundene Balkenstück abstützen, wobei die Balkenstücke, das Verbindungsteil und die Piezowandler gemeinsam die Inertialmasse bilden. Bei dieser Ausbildung kann praktisch der gesamte Bauraum als Inertialmasse genutzt werden, was die Gesamtgröße reduzieren lässt. Da die Piezoaktuatorik Bestandteil der Inertialmasse ist, ergibt sich ferner eine geringere Masse des Gesamtsystems und damit ein günsteres Verhältnis von Inertialmasse zu Gesamtmasse. Außerdem kann der mittlere Federarm dünner ausgebildet werden. Ferner ist es möglich, die Krafteinleitung in den mittleren Federarm sehr weit vom strukturseitigen Fixierpunkt zu entfernen. Gleichzeitig werden die eingeleiteten Momente durch die beiden äußeren Federarme abgestützt. Ferner kann der Massenschwerpunkt dicht an der Struktureinspannstelle liegen, um mechanische Momente zu reduzieren.

Ein Beispiel sieht vor, sieht vor, dass der Abstand zwischen den Balkenstücken und den äußeren Federarmen so gewählt ist, dass dadurch Anschläge gebildet sind, die eine Beschädigung des Kraftgenerator durch übermäßige Ausschläge verhindern. Damit lässt sich für die Ausschläge der Inertialmasse eine Art Anschlag ausbilden; der unzulässig hohe Ausschläge im Resonanzpunkt und damit Beschädigungen verhindert.

Die Erfindung und die Beispiele werden nachfolgend anhand der beigefügten Zeichnungen weiter erläutert. In den Figuren bezeichnen gleiche Bezugszeichen gleiche Bauteile. Dabei zeigt:
Figur 1: eine schematische Ansicht einer ersten Ausführungsform der Erfindung;
Figur 2: eine schematische Ansicht eines Beispiels
Figur 3: eine schematische Ansicht eines Beispiels
Figur 4: die Ausführungsform gemäß Figur 1 mit einer speziellen Ausbildung des Federarmes;
Figur 5: die Ausführungsform gemäß Figur 1 mit einer alternativen Ausführung des Federarmes;
Figuren 6 und 7: zwei weitere Ausführungsformen mit nur zwei Piezowandlern;
Figur 8: drei beispielhafte Piezowandler
Figur 9: eine Beispiel mit trapezförmigem Piezowandler;
Figur 10: drei Ausführungsformen von Federarmen;
Figuren 11 - 20: weitere Beispiele für Kraftgeneratoren;
Figur 21: eine schematische Darstellung einer Anwendung in einem Hubschrauber;
Figur 22: eine Ausführungsform, die eine Abwandlung der Ausführung gemäß Figur 15 darstellt;
Figur 23: Ein weiteres Beispiel für einen Kraftgenerator.

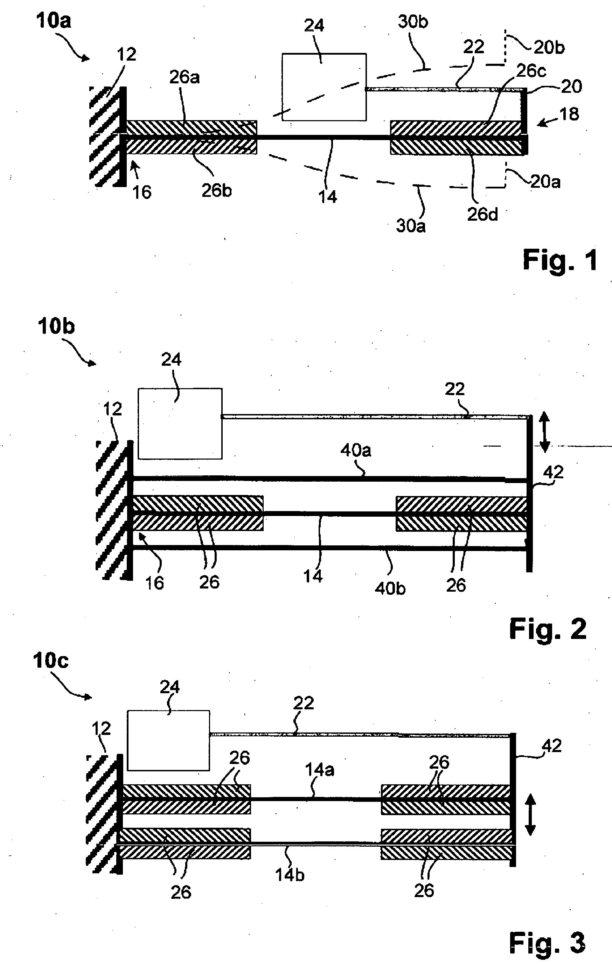

In **Figur 1** ist eine erste Ausführungsform eines Kraftgenerators **10a** schematisch dargestellt, die an einer Struktur **12** befestigt ist. Der Kraftgenerator **10a** umfasst einen Federarm **14**, dessen eines Ende, das Fixierende **16**, an der Struktur **12** starr befestigt ist. Am entgegen gesetzten Schwingungsende **18** des Federarmes **14** ist über ein Verbindungsteil **20** ein Biegearm **22** angebracht, der vorzugsweise parallel zum Federarm **14** angeordnet ist. Am freien Ende des Biegearms **22** ist eine Inertialmasse **24** befestigt. Der Federarm **14** besteht vorzugsweise aus GFK, es können aber auch andere Faserverbund- oder Metallwerkstoffe verwendet werden. Die Inertialmasse **24** wiegt etwa zwischen 1 bis 10 kg und deren Schwerpunkt liegt in Höhe der Mitte des Federarmes **14**.

Am Fixierende **16** des Federarmes **14** sind an diesem auf beiden Seiten Piezowandler **26a, 26b** aufgeklebt oder auf andere Weise ganzflächig fest angebracht. In gleicher Weise sind im Bereich des Schwingungsendes **18** am Federarm **14** auf beiden Seiten weitere zwei Piezowandler **26c, 26d** ganzflächig fixiert. Es sei darauf hingewiesen, dass anstelle von jedem der dargestellten Piezowandler **26** auch zwei oder mehr parallel angeordnet werden können, die dann gemeinsam anzusteuern sind.

Mittels einer nicht dargestellten Steuerschaltung werden die Piezowandler **26a**, **26b, 26c, 26cd** nun über Kreuz angesteuert, sodass die gleich schraffierten Piezowandler **26a** und **26d** bzw. **26b** und **26c** gemeinsam angesteuert werden (dies gilt auch für die weiteren Figuren). Werden beispielsweise die Piezowandler **26a** und **26d** angesteuert (die anderen zwei Piezowandler **26b** und **26c** sind gleichzeitig im Ruhezustand), so verlängern sich beide Piezowandler **26a** und **26d** und bewirken eine S-förmige Verbiegung des Federarmes **14** in der - aus Gründen der Übersichtlichkeit stark überhöhten - Strichlinie **30a.** Dabei bleibt das Verbindungsteil **20a** im Wesentlichen gleich ausgerichtet.

Werden nun die Piezowandler **26a** und **26d** abgeschaltet und stattdessen die Piezowandler **26b** und **26c** angesteuert, so verkürzen sich erstere und verlängern sich zweitere, so dass der Federarm **14** sich S-förmig in der Gegenrichtung verbiegt gemäß der - ebenfalls aus Gründen der Übersichtlichkeit stark überhöhten - Strichlinie **30b**. Durch gezielte wechselweise Ansteuerung der Piezowandlerpaare wird also im Federarm **14** eine erzwungene Schwingung erzeugt, die sich über den Biegearm **22** auf die Inertialmasse **24** fortpflanzt und diese schwingen lässt, wodurch am Fixierende **16** eine oszillierende Kraft entsteht. Über den Hebelarm zwischen Fixierende **16** und Schwerpunkt der Inertialmasse **24** entsteht ferner ein an sich unerwünschtes oszillierendes Moment, das im Fixierende **16** in die Struktur übertragen wird. Da aufgrund der erfindungsgemäßen Ausbildung der Schwerpunkt der Inertialmasse **24** um 50% näher am Fixierende **16** liegt als bei herkömmlichen Kraftgeneratoren, wo die Inertialmasse **24** am Schwingungsende **18** angeordnet ist, sind diese Momente 50% kleiner als im Stand der Technik.

Bei dieser Ausführung ist der Biegearm **22** mit der Inertialmasse **24** lösbar am Verbindungsteil **20** angebracht, so dass der Federarm **14** mit den Piezowandlern **26** und dem Verbindungsteil **20** (zusammen mit einer nicht dargestellten Steuereinrichtung nebst Sensoren zur Erfassung der Vibrationen in der Struktur **12**) ein aktives Grundsystem bilden. Biegearm **22** mit Inertialmasse **24** bilden demgegenüber ein passives Resonatorsystem, das an die speziellen Einsatzbedingungen angepasst werden kann. So kann der erfindungsgemäße Kraftgenerator modulartig in unterschiedlichsten Anwendungen für sehr verschiedene Schwingungsbedingungen verwendet werden, da immer das gleiche aktive Grundsystem verwendet werden kann, während das passive Resonatorsystem anhand der Schwingungsbedingungen ausgewählt wird. Alternativ kann der Biegearm **22** auch unlösbar am Verbindungsteil **20** angebracht und damit dem aktiven Grundsystem zugeordnet sein, so dass nur unterschiedlich schwere Inertialmassen **24** das austauschbare passive Resonatorsystem bilden. Derartige Sensoren erfassen die Vibrationen vorzugsweise in allen drei Richtungen.

In **Figur 2** ist ein Beispiel eines Kraftgenerator **10b** dargestellt, bei der beiderseits des Federarmes **14** mit den Piezowandlern **26** zwei Führungsfedern **40a, 40b** vorgesehen sind, die mit ihren jeweils einen Enden ebenfalls an der Struktur **12** angebracht sind und mit den jeweils anderen Enden an einem Verbindungsteil **42,** an dem ebenfalls der Federarm **14** starr angebracht ist. Durch die beiden Führungsfedern **40a, 40b,** die hinsichtlich Materialeigenschaften und Maßen dem Federarm **14** entsprechen, wird durch die Anregung der Piezowandler **26** der Federarm **14** S-förmig verbogen und aufgrund der Zwangsführung durch beide Führungsfedern **40a, 40b** eine quasi-oszillierende Bewegung des Verbindungsteils **42** erreicht und zwar in gleicher Weise wie in Figur 1 durch die Linien **30a, 30b** angedeutet. Am Verbindungsteil **42** ist der Biegearm **22** angebracht und an diesem wiederum die Inertialmasse **24.** Im Unterschied zur Ausführung gemäß Figur 1 ist der Biegearm **22** jedoch deutlich länger ausgebildet, so dass der Schwerpunkt der Inertialmasse **24** mehr oder weniger auf der Höhe des Fixierpunkts **16** liegt. Soweit die Struktur **12** geeignet geformt ist, kann der Schwerpunkt der Inertialmasse **24** auf gleicher Höhe wie der Fixierpunkt **16** liegen, wodurch zwischen Fixierpunkt **16** und Schwerpunkt der Inertialmasse **24** dann kein Hebelarm verbleibt und damit unerwünschte Momente weitestgehend vermieden werden.

In **Figur 3** ist ein Beispiel eines Kraftgenerators **10c** dargestellt, bei der zwei gleiche Federarme **14a, 14b** parallel zueinander angeordnet und an der Struktur **12** sowie dem Verbindungsteil **42** angebracht sind. Am Verbindungsteil **42** ist der Biegearm **22** angebracht und an diesem wiederum die Inertialmasse **24.** In ähnlicher Weise wie bei Figur 2 wird durch die Parallelstellung der beiden Federarme **14a, 14b** eine weitgehend oszillierende Bewegung des Verbindungsteils **42** erreicht. Dazu werden die jeweiligen Piezowandler **26** an beiden Federarmen **14a, 14b** parallel angesteuert.

Wie bei der Ausführung gemäß Figur 1 ist auch bei den Beispielen gemäß Figur 2 und 3 eine Aufteilung in ein aktives Grundsystem bestehend aus den Federarmen **14, 14a, 14b, 40a, 40b** mit dem Verbindungsteil **42** und ein austauschbares passives Resonatorsystem mit der Inertialmasse **24** und gegebenenfalls dem Biegearm **22** sinnvoll.

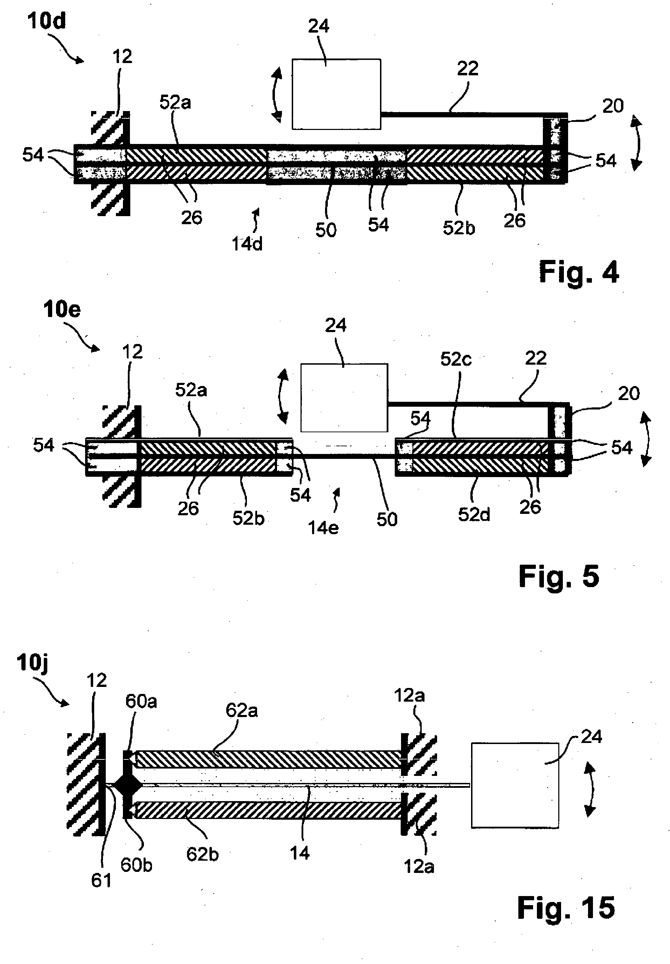

In **Figur 4** ist eine vierte Ausführungsform des Kraftgenerators **10d** dargestellt, der weitgehend der Ausführung **10a** von Figur 1 entspricht. Der wesentliche Unterschied besteht darin, dass der Federarm **14d** aus drei Lagen besteht, nämlich einer Mittellage **50** und zwei Decklagen **52a, 52b.** Beiderseits der Mittellage **50** sind an beiden Enden des Federarmes **14d** Piezowandler **26** angeordnet, die jedoch nicht fixiert, insbesondere nicht verklebt sein müssen. Denn zu den beiden Enden des Federarmes **14d** als auch in der Mitte sind Materialbereiche **54** vorgesehen, die fest mit den Lagen **50, 52a, 52b** verbunden sind und damit eine integrale Struktur des Federarmes **14d** bewirken. Gleichzeitig können sich die Piezowandler **26** beidendig an den Materialbereichen **54** abstützen und damit ihre Längenausdehnung in eine S-förmige Verformung des Federarmes **14d** (analog der Linien **30a, 30b** von Figur 1) umwandeln.

In **Figur 5** ist eine fünfte Ausführungsform des Kraftgenerators **10e** dargestellt, die weitgehend der Ausführung von Figur 4 entspricht. Der einzige wesentliche Unterschied besteht darin, dass die äußeren Decklagen des Federarmes **14e** nicht durchgehend sind, also am strukturseitigen Ende Decklagen **52a, 52b** und am Schwingungsende Decklagen **52c, 52d** vorgesehen sind. Im Mittelbereich ist der Federarm **14e** deutlich weicher als der Federarm **14d,** was den Vorteil hat, dass eine niedrigere Serien-Federsteifigkeit erzielbar ist.

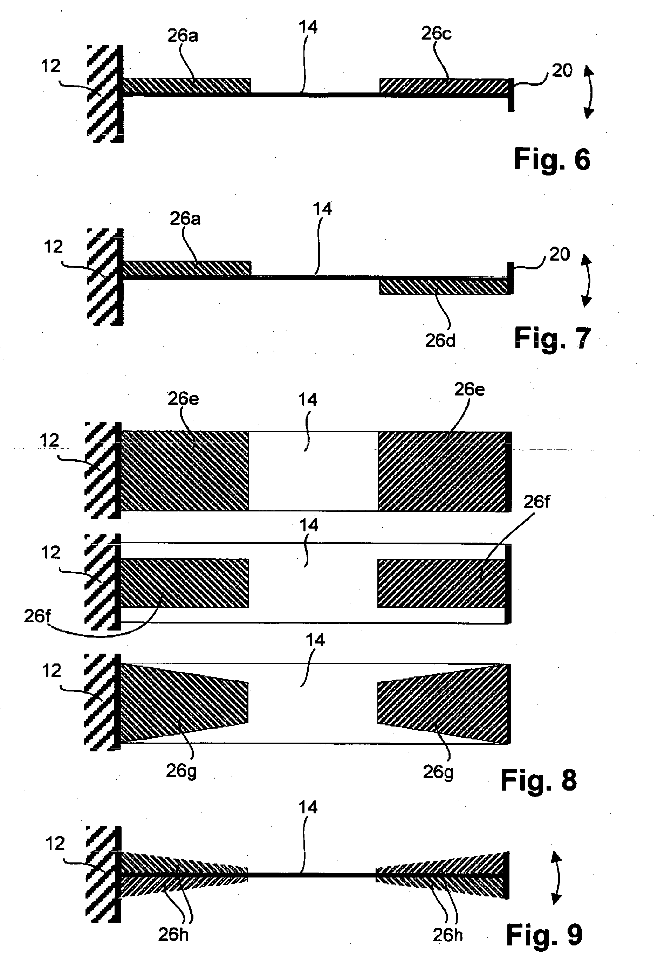

In den **Figuren 6** und 7 sind zwei Ausführungsformen dargestellt, bei denen auf dem Federarm **14** nur zwei Piezowandler **26a, 26c** bzw. **26a, 26d** angebracht sind. Diese Ausführungsformen sind baulich einfacher als die Ausführung mit 4 Piezowandlern, wie in den Figuren 1 bis 5 dargestellt.

In **Figur 8** sind drei Beispiele von Piezowandlern in Schwingungsrichtung betrachtet dargestellt. Bei dem Beispiel gemäß der oberen Darstellung weisen die Piezowandler **26e** die gleiche Breite wie der Federarm **14** auf, wodurch eine maximale Aktuatorleistung erzielbar ist. Bei dem Beispiel gemäß der mittleren Darstellung sind die Piezowandler **26f** schmaler was einen mechanischen Schutz der Piezowandler gewährleistet. Bei dem Beispiel gemäß der unteren Darstellung sind die Piezowandler **26g** trapezförmig ausgebildet, was einen optimierten Wirkungsgrad bzw. eine höhere Kopplung ermöglicht.

In **Figur 9** ist ein Beispiel dargestellt, bei der die Piezowandler **26h** eine trapezförmige Dicke aufweisen, bei der eine höhere Kopplung und eine optimierbare Anpassung der Aktuatoreigenschaften ermöglicht wird. Ein weiterer Vorteil ist eine geringere Biegesteifigkeit an den dünneren Enden, also im Mittelbereich des Federarmes **14**. Bei Verwendung von d33-Piezokristallen für die Piezowandler **26h** lässt sich eine konstante Ausdehnung erreichen. Bei Verwendung von d31-Piezokristallen hingegen lässt sich an den dünneren Enden eine erhöhte Ausdehnung erzielen.

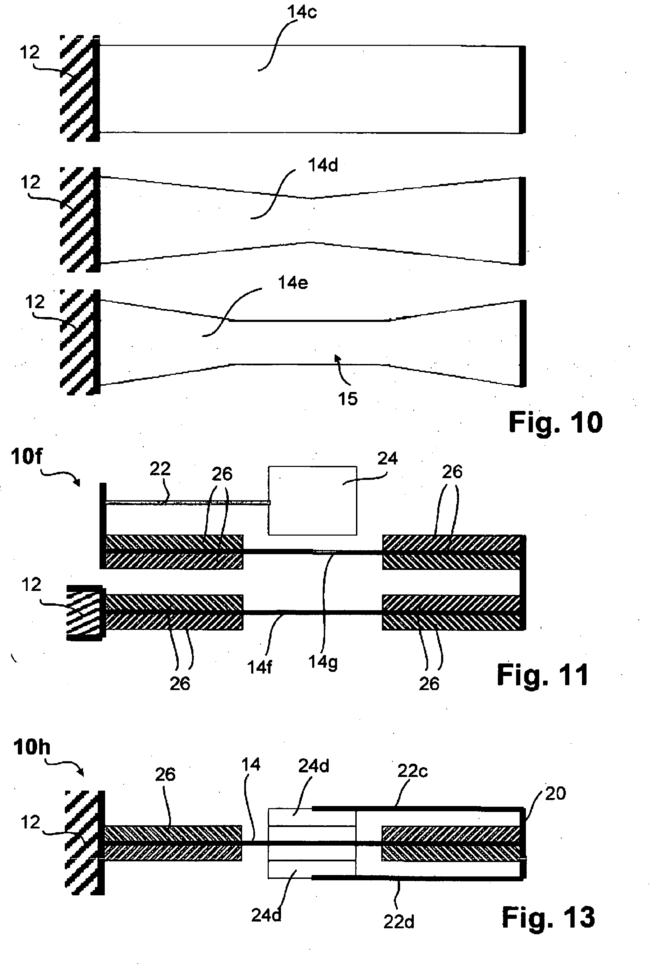

In **Figur 10** sind drei Ausführungsformen von Federarmen dargestellt. Bei der Ausführungsform gemäß der oberen Darstellung weist der Federarm **14c** in Schwingungsrichtung betrachtet eine rechteckige Kontur auf, was die Herstellung vereinfacht. Bei der Ausführungsform gemäß der mittleren Darstellung weist der Federarm **14d** eine Doppeltrapezform auf, wodurch der Wirkungsgrad optimierbar und eine hohe Kopplung erzielbar ist. Bei der Ausführungsform gemäß der unteren Darstellung weist der Federarm **14e** eine Doppeltrapezform mit einem verjüngten Mittelabschnitt **15** auf, wodurch durch Wahl der Einschnürung eine definierte Serien-Federsteifigkeit im Mittelabschnitt **15** erzielbar ist. In gleicher Weise lässt sich der Federarm **14** auch im Längsschnitt betrachtet doppeltrapezförmig ausbilden, also zu den Enden hin dicker und in der Mitte dünner, mit oder ohne verjüngtem Mittelabschnitt, wobei sich die oben beschriebenen Vorteile in gleicher Weise ergeben. Es ist dabei natürlich auch möglich, den oder die Federarm(e) in beiden Richtungen taillierte auszubilden.

In **Figur 11** ist ein Beispiel eines Kraftgenerators **10f** dargestellt, bei dem zwei Federarme **14f, 14g** hintereinander montiert sind und beide Federarme **14f, 14g** mit Piezowandlern **26** versehen sind. Dabei können die oben beschriebenen unterschiedlichen Ausführungsformen für Piezowandler **26e - 26h** zur Anwendung gelangen. Diese Ausführungsform ermöglicht eine Vergrößerung des aktiven Hubes und damit der erzeugten Kraft.

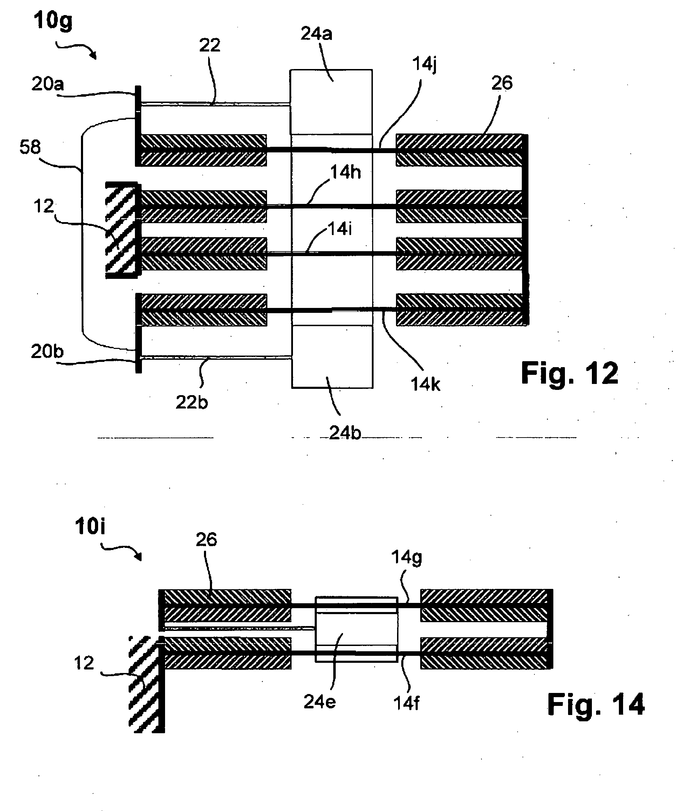

In **Figur 12** ist ein Beispiel eines Kraftgenerators **10g** dargestellt, der Ähnlichkeiten mit den Ausführungen gemäß der Figuren 3 und 11 aufweist insoweit, als zwei parallel an der Struktur **12** einseitig befestigte Federarme **14h, 14i** vorgesehen sind, an denen weitere Federarme **14j, 14k** angebracht sind, und an denen wiederum über Verbindungsteile **20a, 20b** zwei Biegearme **22a, 22b** angebracht sind. An den Biegearmen **22a, 22b** wiederum sind Inertialmassen **24a, 24b** angebracht. Die Verbindungsteile **20a, 20b** sind optional mittels eines Koppelelements **58** miteinander starr gekoppelt, um eine synchronisierte Schwingung der beiden Inertialmassen **24a, 24b** sicherzustellen. Auch die Inertialmassen **24a, 24b** können miteinander verbunden sein. Ein weiterer Vorteil dieser Ausbildung besteht darin, dass durch die Strukturteile **12a** eine Begrenzung des Schwingungsausschlages des Federarmes **14** ermöglicht wird. Durch diese Ausführungsform wird eine parallel- und seriengeschaltete Aktuatorik erzielt.

In **Figur 13** ist ein Beispiel eines Kraftgenerators **10h** dargestellt, die ähnlich der Ausführung gemäß Figur 1 ist. Im Unterschied dazu sind am Verbindungsteil **20** zwei parallel sich erstreckende Biegearme **22c, 22d** vorgesehen, an denen eine ringförmige Inertialmasse **24d** angebracht ist, welche den Federarm **14** umschließt. Dadurch befindet sich der Masseschwerpunkt der Inertialmasse **24d** im Ruhezustand im Federarm **14,** so dass keine zusätzlichen seitlich wirkenden Momente entstehen.

In **Figur 14** ist ein Beispiel eines Kraftgenerators **10i** dargestellt, bei der ähnlich wie bei Figur 11 zwei Federarme **14f, 14g** hintereinander montiert sind und am zweiten Federarm **14g** eine Doppel-T-förmige Inertialmasse **24e** angebracht ist. Dadurch befindet sich der Masseschwerpunkt der Inertialmasse **24e** zentral, so dass keine zusätzlichen seitlich wirkenden Momente entstehen.

In **Figur 15** ist ein Beispiel eines Kraftgenerators **10j** dargestellt, bei der wie bei den bisherigen Ausführungsformen ein Federarm **14** an der Struktur **12** starr befestigt ist. Am freien Ende des Federarmes **14** ist jedoch unmittelbar die Inertialmasse **24** lösbar und damit austauschbar befestigt. Am Federarm **14** selber sind jedoch keine Piezowandler angebracht sondern statt dessen erstrecken sich vom Federarm **14** in der Nähe der Einspannstelle **61** des Federarm **14** zwei Hebelarme **60a, 60b,** an denen wiederum zwei Piezowandler **62a, 62b** angreifen, die sich mit dem jeweils gegenüberliegenden Ende an einer Struktur **12a** abstützen, die Teil der mit **12** bezeichneten Struktur ist. Die beiden Piezowandler **62a, 62b** werden, wie durch die Schraffur angedeutet, gegenphasig angesteuert, so dass sich diese alternierend verlängern und damit über die Hebelarme **60a, 60b** ein Biegemoment in den Federarm **14** einleiten. Der Federarm **14** weist daher keine durch Piezowandler erzeugte Steifigkeiten auf und die Piezowandler **62a**, **62b** sind unabhängig von der Länge des Federarmes **14** wählbar.

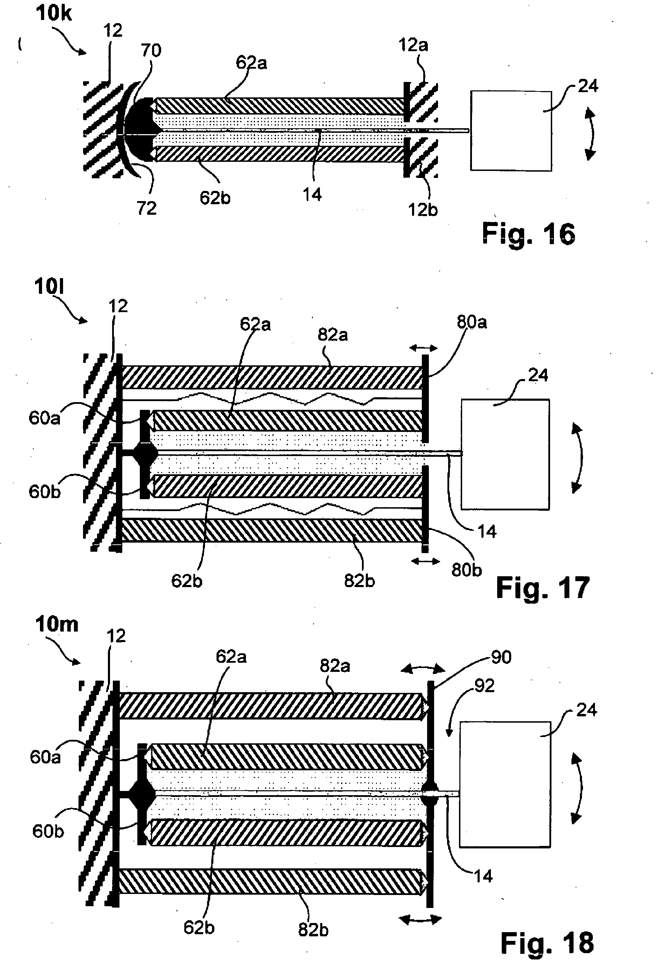

In **Figur 16** ist ein Beispiel eines Kraftgenerators **10k** dargestellt, die weitgehend der Ausführung **10j** von Figur 15 entspricht. Der wesentliche Unterschied dazu besteht darin, dass der Federarm **14** nicht an der Struktur **12** fixiert ist sondern in einem Endstück **70** mit konkaver Wälzfläche endet, wobei die Hebelarme für die Piezowandler **62a, 62b** ebenfalls in das Endstück **70** integriert sind. Die Struktur **12** weist eine konkave Gegenfläche **72** auf, so dass keine unerwünschten Rückstellmomente im Federarm **14** vorhanden sind.

In **Figur 17** ist ein Beispiel eines Kraftgenerators **10l** dargestellt, die derjenigen von Figur 16 ähnelt. Im Unterschied zur Ausführung **10j** stützen sich die den Hebelarmen **60a, 60b** gegenüberliegenden Enden der Piezowandler **62a, 62b** nicht an der Struktur ab sondern sind an Zwischenstützen **80a, 80b** fixiert. An diesen Zwischenstützen **80a, 80b** wiederum sind weitere Piezowandler **82a, 82b** angebracht, die sich mit ihren jeweils entgegen gesetzten Enden an der Struktur **12** abstützen. Wie durch die Schraffuren der Piezowandler **62a, 62b, 82a, 82b** angedeutet, werden die mechanisch verbundenen Piezowandler **62a, 82a** und **62b, 82b** gegenphasig angesteuert, so dass die Zwischenstützen **80a, 80b** durch die Bewegung der Piezowandler **82a** und **82b** in Axialrichtung des Federarmes **14** (zueinander gegenphasig) oszillieren und diese oszillierende Bewegung über die inneren Piezowandler **62a** und **62b** und deren eigene Bewegung verstärkt auf die Hebelarme **60a, 60b** übertragen werden, wodurch der Federarm **14** in Schwingung versetzt wird. Die Zwischenstützen **80a, 80b** werden mittels zweier Vorspannfedern **64** in Richtung der Struktur **12** gezogen, wodurch ein seitliches Wegkippen der Anordnung verhindert wird.

In **Figur 18** ist ein Beispiel eines Kraftgenerators **10m** dargestellt, die im Wesentlichen der Ausführung **10l** von Figur 17 entspricht. Der wesentliche Unterschied besteht darin, dass nicht zwei verschiedene Zwischenstützen (Figur 17: **80a, 80b**) vorhanden sind sondern sich alle vier Piezowandler **62a, 82a** und **62b, 82b** an einer Wippe **90** abstützen, die an einem Drehpunkt **92** an der Struktur **12** aufgehängt ist.

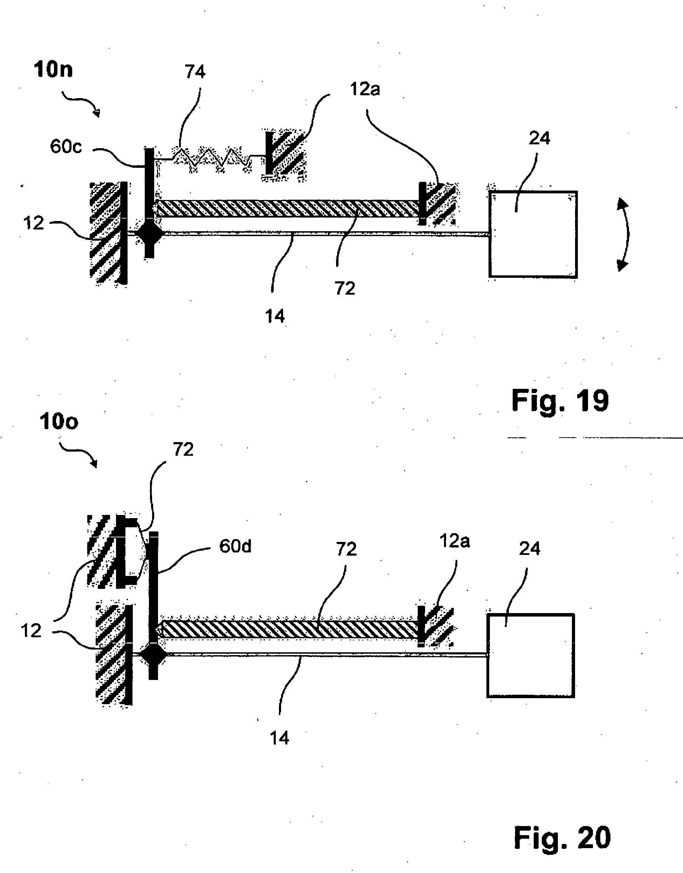

In **Figur 19** ist ein Beispiel eines Kraftgenerators **10n** dargestellt, die sich von den vorher beschriebenen Ausführungsformen dadurch unterscheidet, dass nur ein Piezowandler **72** vorhanden ist, der sich einerseits an der Struktur **12a** und andererseits an einem Hebelarm **60c** abstützt. Darüber hinaus ist am Hebelarm **60c** eine Feder **74** befestigt, die mit dem anderen Ende an der Struktur **12a** fixiert ist. Die Ausführungsform ist baulich einfacher und ermöglicht eine einphasige elektrische Ansteuerung des Piezowandlers **72.** Die in Figur **19** gezeigte Feder **74** ist als Zugfeder ausgebildet. Es ist alternativ genauso möglich, diese als Druckfeder auszubilden. Auch ist es möglich, die Feder **74** (sowohl als Zug- als auch als Druckfeder) nicht am Hebelarm **60c** anzubringen sondern an einem - nicht gezeigten - Hebelarm, der sich entgegengesetzt dem Hebelarm **60c** erstreckt, so wie in Figur 17 der Hebelarm **60b** sich entgegengesetzt dem Hebelarm **60a** erstreckt.

In **Figur 20** ist ein Beispiel eines Kraftgenerators 10o dargestellt, die derjenigen von Figur 19 ähnelt. Im Unterschied dazu ist anstelle einer Zugfeder eine degressive Druckfeder **76** vorgesehen, die sich zwischen der Struktur **12** und dem Hebelarm **60d** abstützt. Die Druckfeder **76** ist vorzugsweise als vorgespannte Tellerfeder ausgebildet. Der Vorteil der degressiven Druckfeder **76** besteht darin, dass der aktive Hub durch die sinkende Vorspannkraft der Druckfeder **76** während der Ausdehnung des Piezowandlers **72** weiter verstärkt wird, was die Schwingungsanregung verstärkt. Diese Ausführungsform ermöglicht auch eine geringere Piezolänge und damit Baugröße des gesamten Kraftgenerators. Die Druckfeder **76** kann auch an einem zweiten - nicht gezeigten - Hebelarm angebracht werden, der sich entgegengesetzt dem Hebelarm **60d** erstreckt, so wie in Figur 17 der Hebelarm **60b** sich entgegengesetzt dem Hebelarm **60a** erstreckt.

Alle vorgenannten Beispiele von Kraftgeneratoren **10a - 10o** werden von einer nicht dargestellten Kontrolleinheit geregelt, die einen oder mehrere Schwingungssensoren aufweist, um die zu kompensierenden Schwingungen an einer oder mehreren Positionen in der Struktur und in einer oder mehreren Richtungen zu erfassen und die Piezowandler **26** mit einer solchen Frequenz anzuregen, dass diese Schwingungen durch die Einleitung von oszillierenden Kräften in die Struktur **12** so weit wie möglich getilgt werden.

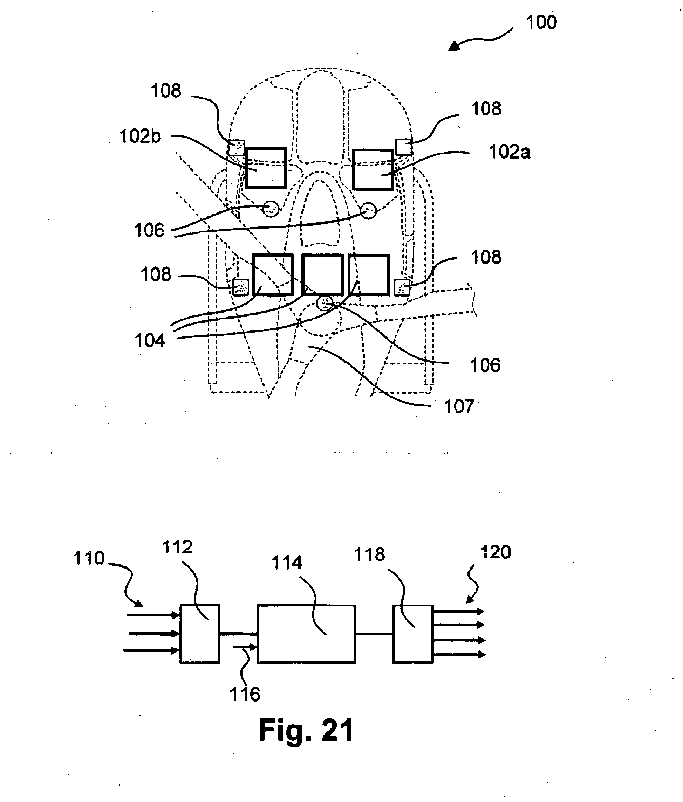

In **Figur 21** ist eine Anwendung von erfindungsgemäßen Kraftgeneratoren in einem schematisch dargestellten Hubschrauber **100** dargestellt. Dieser Hubschrauber **100** umfasst zwei Pilotensitzbereiche **102a, 102b** sowie mehrere Passagiersitze **104.** Am nicht dargestellten Kabinenboden sind drei Sensoren **106** angebracht, welche die durch den Rotor **107** erzeugten Vibrationen an diesen Stellen jeweils in allen drei Raumrichtungen erfassen sowie vier Kraftgeneratoren **108.** Die Sensoren **106** sind über (nur im Blockschaltbild unten angedeutete) Leitungen **110** mit einer Eingangsfiltereinheit **112** verbunden, in dem Tiefpassfilter, vorzugsweise Butterworth-Filter, zur Eliminierung von Hochfrequenzanteilen zwecks Vermeidung von Aliasingeffekten in den Signalen der Sensoren **106** vorgesehen sind. Der Eingangsfiltereinheit **112** ist ein Regler **114** nachgeordnet, der als weitere Eingangsgröße **116** die Rotordrehzahl des nicht gezeigten Antriebsrotors des Hubschraubers **100** aufweist und in Abhängigkeit der Signale der Sensoren **106** und der Rotorgeschwindigkeit **116** über eine Treibereinheit **118** und Anschlussleitungen **120** die vier Kraftgeneratoren **108** einzeln ansteuert. Wesentlich dabei ist, dass durch eine geeignete Regelung eine Minimierung der Vibrationen für die Pilotensitzbereiche **102a, 102b** und/oder den Passagierbereich **104** möglich ist. Dabei müssen weder die Sensoren **106** noch die Kraftgeneratoren **108** in unmittelbarer Nähe der Bereiche **102a, 102b, 104** liegen, deren Vibrationen zu minimieren sind.

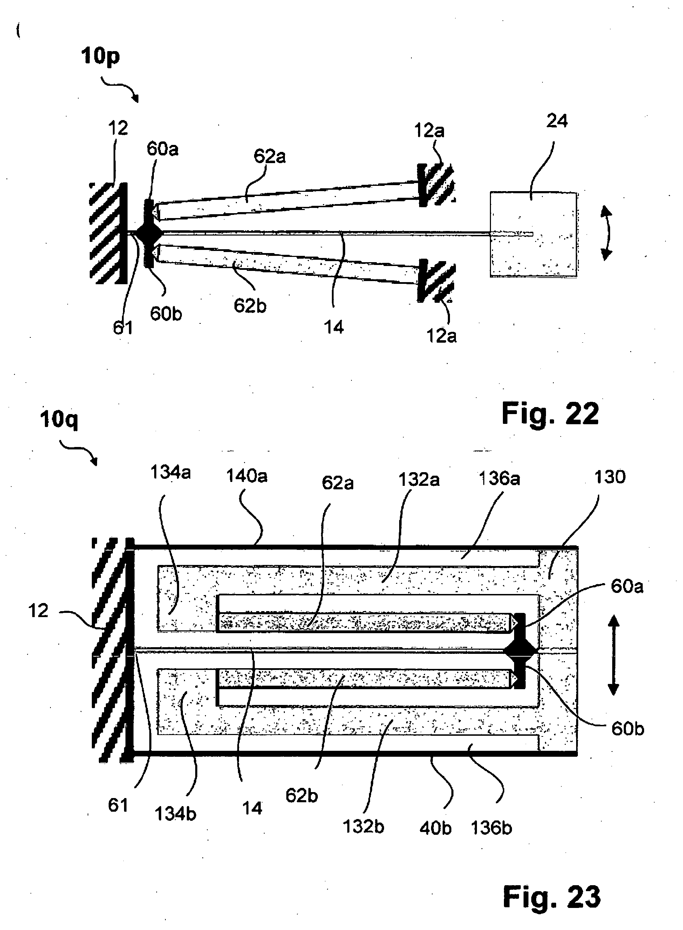

In **Figur 22** ist eine weitere Ausführungsform des Kraftgenerators **10p** dargestellt, die weitgehend der Ausführung von Figur 15 entspricht, so dass die gleichen Bezugszeichen verwendet werden wie in Figur 15 und im Hinblick auf Aufbau und Funktion auf die diesbezügliche Beschreibung verwiesen wird. Im Unterschied zur Ausführung von Figur 15 sind bei dieser Ausführung die beiden Piezowandler **62a, 62b** in einem Winkel zum Federarm **14** ausgerichtet. Dieser Winkel kann nahezu beliebig gewählt werden, beispielsweise auch 90° zur Mittelachse des Federarmes **14.**

In **Figur 23** ist ein Beispiel eines Kraftgenerators **10q** dargestellt, die drei zueinander parallele Federarme **14, 140a, 140b** umfasst, die jeweils mit einem Ende an der Struktur **12** befestigt sind. Die jeweils anderen Enden sind an einem Verbindungsteil **130** angebracht. Von diesem Verbindungsteil **130** stehen zwei Balkenstücke **132a, 132b** ab, die sich vorzugsweise im Wesentlichen parallel zu den Federarmen erstrecken und am jeweils freien Ende Stützansätze **134a, 134b** aufweisen. Der mittlere Federarm 14 weist zwei etwa senkrecht weg stehende Hebelarme **60a, 60b** auf. Zwei Piezowandler **62a, 62b** stützen sich einerseits an den Stützansätzen **134a, 134b** und andererseits an den Hebelarmen **60a, 60b** ab. Durch die wechselseitige Anregung der Piezowandler **62a, 62b** in Verbindung mit den drei parallelen Federarmen **14, 140a, 140b** wird die gesamte Inertialmasse - im wesentlichen bestehend aus Piezowandlern **62a, 62b,** Balkenstücken **132a, 132b** mit Stützansätzen **134a, 134b** und Verbindungsteil **130 -** in Schwingung versetzt und zwar S-Schlag-förmig. Vorzugsweise ist der Spalt **136a**, **136b** zwischen den äußeren Federarmen **140a**, **140b** und den Balkenstücken **132a, 132b** so breit, dass bei einem bestimmten Maximalausschlag diese Bauteile gegeneinander kommen, wodurch der Maximalausschlag der Inertialmasse wirksam begrenzt werden kann auf einen Wert, der eine Beschädigung ausschließt.

## Patentansprüche

1. Kraftgenerator zur Anbringung an einer Struktur (12), um steuerbar Schwingungskräfte zur Schwingungsbeeinflussung in diese einzuleiten, umfassend mindestens einen Federarm (14) mit einem Fixierende (16) zur Befestigung an der Struktur (12) und mit einem Schwingungsende (18), an dem über einen sich in Richtung zum Fixierende (16) erstreckenden Biegearm (22) eine Inertialmasse (24) befestigt ist, wobei am Federarm (14) zu dessen Biegeverformung an beiden Enden (16, 18) jeweils mindestens ein Piezowandler (26) angebracht ist und der Schwerpunkt der Inertialmasse (24) in Höhe der Mitte des Federarmes (14) angeordnet ist, **dadurch gekennzeichnet, dass** der Biegearm (22) mit Inertialmasse (24) lösbar an einem Verbindungsteil (20) am Schwingungsende (18) angebracht ist und die Inertialmasse (24) und/oder der Biegearm (22) mit Inertialmasse (24) austauschbar sind.

2. Kraftgenerator nach Anspruch 1, **dadurch gekennzeichnet, dass** der Federarm (14) eine Mittellage (50) und zwei damit gekoppelte Decklagen (52) umfasst, wobei die Piezowandler (26) jeweils zwischen der Mittellage (50) und einer der Decklagen (52) angeordnet sind.

3. Kraftgenerator nach einem der vorherigen Ansprüche, **dadurch gekennzeichnet, dass** der Federarm (14) eine rechteckige oder taillierte Längsschnittsform aufweist.

4. Kraftgenerator nach Anspruch 2 **dadurch gekennzeichnet, dass** sich die Decklagen (52) von beiden Enden her weiter als die Piezowandler (26) erstrecken und dort mittels Stützabschnitten (54) mit der Mittellage (50) verbunden sind, wobei sich die Piezowandler (26) an den Stützabschnitten (54) abstützen, so dass im mittleren Bereich des Federarmes (14) nur die Mittellage (50) vorhanden ist.

5. Kraftgenerator nach Anspruch 1, **dadurch gekennzeichnet, dass** am Ende eines jeden Federarmes (14) ein sich in Gegenrichtung erstreckender, zweiter Federarm (14g, 14j, 14k) mit beidendig angebrachten Piezowandlern (26) angebracht ist, an dessen anderem Ende ein Biegearm (22, 22a, 22b) mit Inertialmasse (24, 24a, 24b) angebracht ist.

6. Luftfahrzeug, umfassend mindestens einen Sensor (106) zur Erfassung von Vibrationen, mindestens einen Kraftgenerator (10) nach einem oder mehreren der vorherigen Ansprüche sowie eine Regeleinheit (114) zur Ansteuerung des mindestens einen Kraftgenerators (108) auf der Grundlage der Signale des mindestens einen Sensors (106).

7. Luftfahrzeug nach Anspruch 6, **dadurch gekennzeichnet, dass** die Regeleinheit (114) als weitere Stellgröße die Drehzahl eines Antriebsrotors (107) aufweist.

## Claims

1. Force generator for mounting on a structure (12) in order to introduce vibrational forces into the structure in a controllable manner for influencing vibration, comprising at least one spring arm (14) having a fixed end (16) for fastening to the structure (12), and having a vibrating end (18) to which an inertial mass (24) is fastened via a bending arm (22) extending in the direction of the fixed end (16), at least one piezoelectric transducer (26) in each case being mounted at both ends (16, 18) on the spring arm (14) for the bending deformation thereof, and the centre of gravity of the inertial mass (24) being located at the level of the middle of the spring arm (14), **characterized in that** the bending arm (22) together with the inertial mass (24) is detachably mounted on a connecting part (20) at the vibrating end (18), and the inertial mass (24) and/or the bending arm (22) together with the inertial mass (24) are exchangeable.

2. Force generator according to claim 1, **characterized in that** the spring arm (14) comprises a centre layer (50) and two cover layers (52) coupled thereto, the piezoelectric transducers (26) in each case being located between the centre layer (50) and one of the cover layers (52).

3. Force generator according to one of the preceding claims, **characterized in that** the spring arm (14) has a longitudinal section with a rectangular or tapered shape.

4. Force generator according to claim 2, **characterized in that** the cover layers (52) extend from both ends farther than the piezoelectric transducers (26), and are connected there to the centre layer (50) by means of support sections (54), the piezoelectric transducers (26) being supported on the support sections (54) so that only the centre layer (50) is present in the middle area of the spring arm (14).

5. Force generator according to claim 1, **characterized in that** a second spring arm (14g, 14j, 14k) extending in the opposite direction and having piezoelectric transducers (26) attached at both ends is mounted at the end of each spring arm (14), and a bending arm (22, 22a, 22b) having an inertial mass (24, 24a, 24b) is mounted at the other end of the second spring arm.

6. Aircraft, comprising at least one sensor (106) for detecting vibrations, at least one force generator (10) according to one or more of the preceding claims, and a control unit (114) for controlling the at least one force generator (108) on the basis of the signals of the at least one sensor (106).

7. Aircraft according to claim 6, **characterized in that** the control unit (114) has the rotational speed of a drive rotor (107) as a further manipulated variable.

## Revendications

1. Générateur de force à monter sur une structure (12), pour introduire, de manière commandable, des forces d'oscillation dans celle-ci dans le but d'influer sur cette dernière au moyen d'oscillations, comprenant au moins un bras élastique (14) ayant une extrémité (16) de fixation à la structure (12) et une extrémité oscillante (18), à laquelle est fixée une masse inertielle (24) via un bras flexible (22) s'étendant en direction de l'extrémité de fixation (16), moyennant quoi respectivement au moins un transducteur piézo-électrique (14) est disposé aux deux extrémités (16, 18) du bras élastique (14) pour générer une déformation en flexion de celui-ci et le centre de gravité de la masse inertielle (24) est situé au niveau du centre du bras élastique (14), **caractérisé en ce que** le bras flexible (22) muni de la masse inertielle (24) est monté de manière amovible sur une pièce de jonction (20) à l'extrémité oscillante (18) et la masse inertielle (24) et/ou le bras flexible (22) muni de la masse inertielle (24) peuvent être échangés.

2. Générateur de force selon la revendication 1, **caractérisé en ce que** le bras élastique (14) comporte une couche médiane (50) et deux couches de revêtement (52) accouplées à celle-ci, les transducteurs piézo-électriques (26) étant disposés respectivement entre la couche médiane (50) et une des couches de revêtement (52).

3. Générateur de force selon l'une quelconque des revendications précédentes, **caractérisé en ce que** le bras élastique (14) a une section longitudinale de forme rectangulaire ou cintrée.

4. Générateur de force selon la revendication 2, **caractérisé en ce que** les couches de revêtement (52) s'étendent à partir des deux extrémités au-delà des transducteurs piézo-électriques (26) et de là sont reliées à la couche médiane (50) au moyen de tronçons de support (54), moyennant quoi les transducteurs piézo-électriques (26) s'appuient sur les tronçons de support (54), de telle sorte que dans la zone centrale du bras élastique (14), seule la couche médiane (50) est présente.

5. Générateur de force selon la revendication 1, **caractérisé en ce qu'**à l'extrémité de chaque bras élastique (14), est placé un second bras élastique (14g, 14j, 14k) s'étendant dans le sens inverse et pourvu de transducteurs piézo-électriques (26) disposés aux deux extrémités, à l'autre extrémité duquel un bras flexible (22, 22a, 22b) pourvu d'une masse inertielle (24, 24a, 24b) est installé.

6. Aéronef, comprenant au moins un capteur (106) destiné à détecter des vibrations, au moins un générateur de force (10) selon l'une ou plusieurs revendications précédentes et une unité de réglage (114) destinée à exciter le au moins un générateur de force (108) sur la base des signaux du au moins un capteur (106).

7. Aéronef selon la revendication 6, **caractérisé en ce que** l'unité de réglage (114) comprend, en tant qu'autre grandeur réglante, la vitesse de rotation d'un rotor d'entraînement (107).
